(19) Europäisches Patentamt / European Patent Office / Office européen des brevets

(11) **EP 3 262 210 B1**

(12) **FASCICULE DE BREVET EUROPEEN**

(45) Date de publication et mention de la délivrance du brevet:
**12.09.2018 Bulletin 2018/37**

(21) Numéro de dépôt: **16707892.2**

(22) Date de dépôt: **10.02.2016**

(51) Int Cl.:
*H05H 1/46* *(2006.01)*       *B05D 7/02* *(2006.01)*
*B05D 7/20* *(2006.01)*       *B05D 1/00* *(2006.01)*
*C23C 16/26* *(2006.01)*      *G01N 25/72* *(2006.01)*
*C23C 16/04* *(2006.01)*      *C23C 16/511* *(2006.01)*
*C23C 16/52* *(2006.01)*      *H01J 37/32* *(2006.01)*
*G01N 21/84* *(2006.01)*      *G01N 21/90* *(2006.01)*
*B29C 59/14* *(2006.01)*

(86) Numéro de dépôt international:
**PCT/FR2016/050299**

(87) Numéro de publication internationale:
**WO 2016/135390 (01.09.2016 Gazette 2016/35)**

(54) **PROCEDE DE TRAITEMENT PAR PLASMA DE RECIPIENTS, COMPRENANT UNE PHASE D'IMAGERIE THERMIQUE**

PLASMABEHANDLUNGSVERFAHREN MIT THERMISCHER BILDGEBUNGSPHASE FÜR EINEN BEHÄLTER

CONTAINER PLASMA TREATMENT PROCESS COMPRISING A THERMAL IMAGING PHASE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.02.2015 FR 1551538**

(43) Date de publication de la demande:
**03.01.2018 Bulletin 2018/01**

(73) Titulaire: **Sidel Participations**
**76930 Octeville-sur-Mer (FR)**

(72) Inventeur: **DEAU, Thierry**
**76930 Octeville-sur-mer (FR)**

(74) Mandataire: **Grassin d'Alphonse, Emmanuel Jean Marie**
**Sidel Participations**
**Avenue de la Patrouille de France**
**76930 Octeville-sur-mer (FR)**

(56) Documents cités:
EP-A1- 1 881 088        WO-A2-2011/015330
DE-A1- 10 138 167       FR-A1- 2 988 846
JP-A- H04 174 327       US-A1- 2010 111 511

**Description**

L'invention a trait au traitement des récipients en polymère (tel que PET) par plasma, et plus précisément par dépôt chimique en phase vapeur assisté par plasma, d'une couche mince - typiquement (mais non exclusivement) de carbone amorphe hydrogéné.

Un carbone amorphe hydrogéné est un matériau comprenant des atomes de carbone et d'hydrogène, que l'on désigne couramment par la formule a-C:H, qui apparaît au centre du diagramme ternaire d'équilibre carbone-hydrogène, tel qu'illustré notamment dans l'Encyclopédie Ullmann de l'industrie chimique, 5e éd., Vol. A26, p.720.

Les couches (ou films) minces (d'une épaisseur comprise entre 0,050 μm et 0,200 μm) de carbone amorphe hydrogéné ont la propriété de former une barrière notamment aux ultraviolets, aux molécules d'oxygène et au dioxyde de carbone. En l'absence d'une telle couche barrière, les ultraviolets et l'oxygène traversent la paroi du récipient et sont susceptibles d'en dégrader le contenu, notamment la bière ou le thé. Quant au dioxyde de carbone des boissons carbonatées (dites gazeuses), il a également tendance à s'échapper par migration au travers de la paroi du récipient.

Classiquement, et comme décrit notamment dans le brevet européen EP 1 068 032 (Sidel Participations), pour former une couche mince sur la paroi interne d'un récipient, on commence par introduire le récipient dans une enceinte placée dans une cavité conductrice et transparente à l'essentiel du spectre micro-ondes.

On dépressurise ensuite à la fois le récipient et l'enceinte pour obtenir, d'une part, dans le récipient, un vide poussé (de quelques μbars - rappelons que 1 μbar = $10^{-6}$ bar) nécessaire à l'établissement du plasma et, d'autre part, dans l'enceinte à l'extérieur du récipient, un vide moyen (de l'ordre de 30 mbar à 100 mbar) pour éviter que le récipient ne se contracte sous l'effet de la différence de pression de part et d'autre de sa paroi.

Puis on injecte dans le récipient un gaz précurseur (typiquement un hydrocarbure sous forme gazeuse, tel que de l'acétylène, $C_2H_2$), puis on génère dans la cavité (et donc dans l'enceinte) un champ électromagnétique de micro-ondes pour activer (et entretenir pendant une durée prédéterminée, généralement de l'ordre de quelques secondes) dans le gaz un plasma qui dissocie les molécules du gaz puis les recombine en diverses espèces (notamment CH, CH2, CH3 dans le cas d'un hydrocarbure tel que l'acétylène) qui se déposent en couche mince sur la paroi interne du récipient.

Pour remplir la fonction de barrière, non seulement la couche doit être suffisamment épaisse en moyenne, mais en outre cette épaisseur doit être assez uniforme, car toute zone insuffisamment revêtue peut offrir un moindre effet barrière, au détriment de la protection du contenu du récipient.

Une bonne homogénéité de la couche est difficile à obtenir de manière répétée car sa distribution est sensible aux moindres variations de plusieurs paramètres (au nombre desquels la forme du récipient), et des dérives imperceptibles (et cependant préjudiciables à la qualité des récipients) peuvent se produire d'un cycle à l'autre.

Mettre au rebut les récipients non conformes, comme le préconise le document CA 2 859 157, n'est qu'un pis-aller, car il conduit à un gaspillage de temps et d'énergie sans pour autant corriger les défauts affectant la production. "Par ailleurs, le document EP1881088 décrit un dispositif pour le dépôt d'un revêtement sur une face interne d'un récipient. Le document WO2011015330 décrit un procédé de dépôt chimique en phase vapeur (CVD) pour produire des tiges de silicium."

Un premier objectif est de proposer une solution permettant d'améliorer l'homogénéité de la couche barrière.

Un deuxième objectif est d'améliorer la qualité du dépôt dans les récipients traités.

Un troisième objectif est de garantir, autant que possible, la répétitivité du cycle de traitement d'un récipient à l'autre.

A cet effet, il est proposé un procédé de traitement d'un récipient par plasma pour le dépôt, sur une face interne du récipient, d'une couche barrière, ce procédé comprenant les opérations consistant à :

- introduire le récipient dans une enceinte transparente aux micro-ondes ;
- créer dans le récipient une dépression interne d'une valeur prédéterminée ;
- créer dans l'enceinte une dépression externe d'une valeur prédéterminée ;
- injecter dans le récipient un gaz précurseur selon un débit prédéterminé ;
- soumettre l'enceinte à une onde électromagnétique de fréquence prédéterminée dans le domaine des micro-ondes et de puissance prédéterminée, de façon à exciter un plasma dans le gaz précurseur ;
- maintenir la dépression interne, la dépression externe, l'injection de gaz précurseur et l'onde électromagnétique pour entretenir le plasma pendant une durée de traitement prédéterminée ;
- éteindre le plasma ;
- après l'extinction du plasma, réaliser une image thermique du récipient ;
- comparer l'image thermique du récipient avec une image thermique de référence mémorisée ;
- si l'image thermique du récipient diffère de l'image thermique de référence, modifier au moins l'un des paramètres suivants : dépression interne, dépression externe, débit de gaz précurseur, fréquence des micro-ondes, puissance des micro-ondes, durée du traitement.

Ce procédé permet, en réalisant une cartographie thermique du récipient, de contrôler indirectement la répartition des espèces déposées, et donc l'épaisseur de la couche mince présente sur la paroi du récipient. L'épaisseur de la couche peut alors, dans une certaine mesure, être ajustée par modification des paramètres, notamment pour être plus homogène.

Diverses caractéristiques supplémentaires peuvent être prévues, seules ou en combinaison :

- le générateur est un magnétron et l'enceinte est logée dans une cavité munie de plateaux mobiles réalisés dans un matériau électriquement conducteur, la position des plateaux faisant dans ce cas partie des paramètres modifiables si l'image thermique du récipient diffère de l'image thermique de référence ;
- la dépression interne étant réalisée au moyen d'une pompe à vide primaire, la modification de la dépression interne consiste à modifier le débit de cette pompe à vide primaire ;
- la dépression externe étant réalisée au moyen d'une pompe à vide secondaire, la modification de la dépression externe consiste à modifier le débit de cette pompe à vide secondaire ;
- le gaz précurseur étant injecté dans le récipient au moyen d'un injecteur, la modification du débit de gaz précurseur consiste à régler l'ouverture de l'injecteur ;
- la comparaison est effectuée par corrélation d'image, notamment par corrélation d'image locale.

D'autres objets et avantages de l'invention apparaîtront à la lumière de la description d'un mode de réalisation, faite ci-après en référence aux dessins annexés dans lesquels :

- la figure 1 est une vue en coupe partielle illustrant une installation pour le traitement de récipients par plasma, pour former sur la paroi interne de ceux-ci une couche barrière ;
- la figure 2 est une image thermique d'un récipient traité dans une installation telle que représentée sur la figure 1, accompagnée, pour la lecture de l'image, d'une palette de couleurs correspondant à différentes gammes de températures ;
- la figure 3 est une image thermique d'un récipient de référence tel qu'idéalement traité par plasma ;
- la figure 4 est un schéma illustrant une technique de corrélation d'image appliquée entre l'image thermique de la figure 3 et l'image thermique de la figure 2.

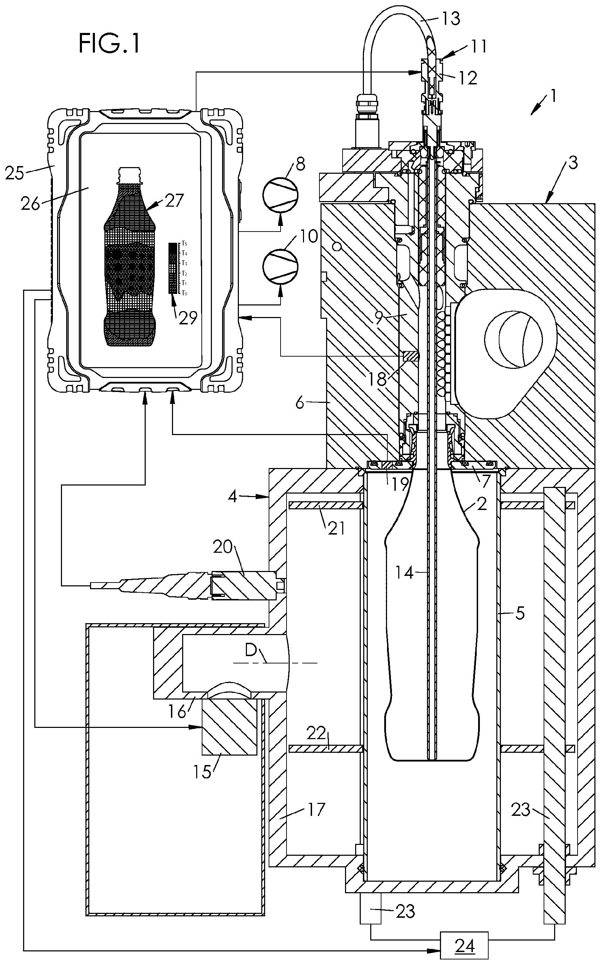

Sur la figure 1 est partiellement représentée une installation **1** pour le traitement de récipients **2** en polymère par dépôt chimique en phase vapeur assisté par plasma, sur une paroi interne des récipients **2,** d'une couche barrière mince.

Chaque récipient **2** à traiter (typiquement une bouteille ou un flacon) présente sa forme finale ; il a par exemple été formé par soufflage ou étirage soufflage à partir d'une préforme. Selon un mode particulier de réalisation, le récipient **2** est réalisé en PET (polytéréphtalate d'éthylène).

La couche à déposer peut être composée de carbone amorphe hydrogéné, qui présente l'avantage de former une barrière aux gaz tels que l'oxygène et le dioxyde de carbone, auxquels le PET seul est relativement perméable. D'autres types de couches minces que celles à base de carbone peuvent convenir, pour les mêmes applications, notamment à base d'oxyde de silicium ou d'aluminium.

L'installation 1 comprend une pluralité de postes 3 de traitement tous semblables, chacun configuré pour accueillir et traiter un seul récipient 2 à la fois. L'installation 1 comprend en outre une structure (de préférence tournante, telle qu'un carrousel) sur laquelle sont montés les postes 3 de traitement, qui sont par exemple au nombre de vingt-quatre, ou encore de quarante-huit, de sorte à permettre un traitement des récipients 2 à cadence industrielle (de l'ordre de plusieurs dizaines de milliers par heure).

Chaque poste **3** de traitement comporte une cavité **4** externe de forme avantageusement cylindrique, réalisée dans un matériau conducteur, par exemple métallique (typiquement en acier ou, de préférence, en aluminium ou dans un alliage d'aluminium), et dimensionnée pour permettre l'établissement en son sein d'une onde électromagnétique stationnaire à une fréquence de résonance prédéterminée dans le domaine des microondes, et plus précisément proche de 2 450 MHz (ou 2,45 GHz).

Chaque poste **3** de traitement comprend en outre une enceinte **5** tubulaire, montée de manière coaxiale et étanche dans la cavité **4** et réalisée dans un matériau transparent à un large spectre électromagnétique. Plus précisément, l'enceinte **5** est transparente au moins aux micro-ondes ainsi que, de préférence, au domaine infrarouge. Selon un mode de réalisation, le matériau dans lequel est réalisée l'enceinte **5** est du quartz.

Selon un mode de réalisation particulier illustré sur la figure 1, l'enceinte **5** est, à une extrémité inférieure, emboîtée de manière étanche dans une zone complémentaire formée dans une paroi inférieure de la cavité **4.**

A une extrémité supérieure, l'enceinte **5** est fermée de manière étanche par un couvercle **6** amovible permettant d'introduire un récipient **2** dans l'enceinte **5** pour permettre son traitement, et de l'en retirer après la fin du traitement.

Comme on le voit sur la figure 1, le poste **3** de traitement est muni d'un support **7** (ici de type fourchette) qui coopère avec un col du récipient **2** pour assurer la suspension de celui-ci dans l'enceinte **5,** et divers joints qui assurent l'étanchéité du volume interne du récipient **2** vis-à-vis de l'enceinte **5.**

Sont ainsi séparés de manière étanche :

- l'intérieur du récipient **2,**
- l'intérieur de l'enceinte **5** à l'extérieur du récipient **2,**
- l'intérieur de la cavité à l'extérieur de l'enceinte **5.**

Pour plus de détail sur la réalisation de l'étanchéité, l'homme du métier pourra se référer à la description de la demande de brevet US 2010/0007100.

Le poste **3** de traitement comprend :

- un circuit primaire de vide comprenant une pompe **8** à vide primaire permettant de faire un vide poussé (de l'ordre de quelques microbars) dans le récipient **2,** via une tuyère **9** formée dans le couvercle **6** et débouchant dans le récipient **2** (lorsque celui-ci est présent), et
- un circuit secondaire de vide comprenant une pompe **10** à vide secondaire permettant de faire un vide moyen (de l'ordre de quelques millibars) dans l'enceinte **5** à l'extérieur du récipient **2,** pour éviter que celui-ci ne se contracte sous l'effet de la différence de pression de part et d'autre de sa paroi.

Le poste **3** de traitement comprend également un dispositif **11** d'injection, dans l'enceinte **5,** d'un gaz précurseur tel que de l'acétylène (de formule $C_2H_2$). Comme on le voit sur la figure 1, ce dispositif **11** comprend un injecteur **12** relié, via un flexible **13,** à une source (non représentée) de gaz précurseur, et un tube **14** d'injection branché sur l'injecteur **12** pour acheminer le gaz précurseur dans le récipient **2.** L'injecteur **12** est à ouverture réglable, de sorte à permettre une variation du débit de gaz précurseur dans le récipient **2.**

Pour plus de détail concernant la structure de la cavité **4,** l'homme du métier pourra se référer à la description de la demande de brevet US 2010/0206232.

Le poste **3** de traitement comprend également un générateur **15** d'ondes électromagnétiques dans le domaine des micro-ondes, et plus précisément, ici, au voisinage de 2 450 MHz (ou 2,45 GHz). Selon un mode de réalisation illustré sur la figure 1, le générateur **15** est un magnétron, et il est couplé à la cavité **4** au moyen d'un guide **16** d'onde qui débouche dans la cavité **4** par une fenêtre pratiquée au travers d'une paroi **17** latérale de la cavité **4** en formant une direction **D** principale de propagation des micro-ondes.

Le poste **3** de traitement comprend en outre un capteur **18** primaire de pression débouchant dans la tuyère **8** pour y mesurer la pression (et donc celle régnant dans le récipient **2,** qui est en communication avec la tuyère **8**). Le poste **3** de traitement comprend également un capteur **19** secondaire de pression débouchant dans le volume interne délimité par l'enceinte **5** pour y mesurer la pression. Dans l'exemple illustré, le capteur **19** secondaire de pression est monté sous le couvercle **6,** et s'étend au travers d'une lumière pratiquée dans le support **7.**

L'installation comprend au moins une caméra **20** thermique agencée pour réaliser une image thermique du récipient **2.** Une telle image, réalisée dans le domaine infrarouge du spectre électromagnétique, permet de cartographier le récipient **2** en température.

La caméra **20** est par ex. du modèle A315 commercialisé par la société FLIR, qui permet de réaliser des images dans la gamme thermique de -20°C à 120°C avec une résolution de 320x240 pixels.

Selon un mode particulier de réalisation (non illustré), la caméra **20** est commune à plusieurs (et par exemple à tous les) postes **3** de traitement, en étant positionnée de manière fixe au droit d'un point de décharge auquel les récipients sont évacués des cavités **4** après avoir été traités. Dans ce cas, la caméra **20** thermique pointe vers chaque récipient **2** à la sortie de la cavité **4.**

Selon un autre mode de réalisation qui correspond à l'illustration de la figure 1, chaque poste **3** de traitement intègre une caméra **20** thermique.

Ainsi, dans l'exemple illustré, la caméra **20** thermique est montée sur la paroi **17** latérale de la cavité **4** au droit de la zone où se trouve le récipient **2.** L'enceinte **5** étant transparente aux longueurs d'onde du domaine infrarouge, elle ne forme pas obstacle au rayonnement issu du récipient **2,** qui peut donc être capté sans atténuation par la caméra **19** thermique.

Le récipient **2** étant un solide de révolution, plusieurs caméras **20** peuvent être prévues, réparties autour du récipient, par ex. à 120°. Cependant au moins une caméra **20** (celle représentée sur la figure 1) est disposée à l'aplomb du guide **16** d'onde et pointe dans la direction **D** de propagation des ondes.

Comme on le voit par ailleurs sur la figure 1, le poste **3** de formage comprend une paire de plateaux annulaires superposés, à savoir un plateau **21** supérieur et un plateau **22** inférieur qui sont disposés dans la cavité **4** autour de l'enceinte **5** en étant décalés verticalement de manière à être situés de part et d'autre du guide **16** d'onde. Les plateaux **21, 22** sont réalisés dans un matériau électriquement conducteur (par ex. en acier ou en aluminium) et ont pour fonction de confiner le champ électromagnétique sur la zone où se trouve le récipient **2.** Les plateaux **21, 22** sont fixés sur des tiges **23** qui s'étendent verticalement au travers de la cavité **4** et permettent un réglage de la position des plateaux **21, 22,** de façon à permettre le traitement de récipients de tailles variées. A cet effet, l'une au moins des tiges **23** peut être filetée en étant en prise hélicoïdale avec un taraudage ménagé dans l'un au moins des plateaux **21, 22.** La rotation de la tige **23** filetée permet ainsi de régler la position verticale du (des) plateau(x) **21, 22.**

Pour plus de précision, il est préférable de pouvoir régler indépendamment la position verticale du plateau **21** supérieur et celle du plateau **22** inférieur. A cet effet, l'une des tiges **23** est par exemple en prise hélicoïdale avec le plateau **21** supérieur tandis qu'une autre tige **23** est en prise hélicoïdale avec le plateau **22** inférieur. Une motorisation **24** permet de faire tourner la (les) tige(s) **23** pour régler la position verticale de chaque plateau **21, 22.**

Dans l'exemple illustré, où le poste **3** de traitement intègre une (ou plusieurs) caméra(s) **20** thermique(s), les tiges **23** sont positionnées de façon à ne pas se trouver entre la (ou les) caméra(s) **20** thermique(s) et le récipient **2,** de sorte à ne pas induire d'ombre sur l'image thermique de celui-ci. Selon un mode de réalisation illustré sur la figure 1, les tiges **23** sont au nombre de trois, réparties à 120° autour de l'enceinte **5,** l'une de ces tiges **23** étant diamétralement opposée à la caméra **20** thermique. En variante, les tiges **23** sont au nombre de deux, et sont diamétralement opposées dans un plan perpendiculaire à la direction **D** de propagation.

L'installation **1** comprend par ailleurs une unité **25** de contrôle informatisée (sous forme d'un automate programmable, d'un ordinateur ou plus simplement d'un processeur), qui peut être dédiée au poste **3** de traitement ou commune à l'ensemble de ceux-ci. L'unité **25** de contrôle est avantageusement équipée d'une interface **26** graphique (ici sous forme d'un écran plat, éventuellement tactile) permettant d'afficher des informations, et notamment une image **27** thermique du récipient **2** réalisée au moyen de la caméra **20.**

L'unité **25** de contrôle est reliée :

- à la pompe **8** à vide primaire dont elle peut régler le débit ;
- à la pompe **10** à vide secondaire dont elle peut aussi régler le débit ;
- au capteur **18** primaire de pression qui communique à l'unité **25** de contrôle les mesures de pression dans la tuyère **9** (et donc dans le récipient **2**) ;
- au capteur **19** secondaire de pression qui communique à l'unité **25** de contrôle les mesures de pression dans l'enceinte **5** ;
- à l'injecteur **12** dont l'unité **25** de contrôle peut ainsi régler le débit par réglage de son ouverture ;
- à la (ou chaque) caméra **20** thermique qui communique à l'unité **25** les mesures thermiques réalisées sur le récipient **2** ;
- au générateur **15** dont l'unité **25** de contrôle peut régler la puissance ainsi que, le cas échéant, la fréquence des micro-ondes lorsque cette fréquence est réglable ;
- à la motorisation **24** pour régler, le cas échéant, la position verticale des plateaux **21, 22** et ainsi accorder la cavité **4** au générateur **15.**

Les raccordements de l'unité **25** de contrôle à ces divers composants peuvent être filaires (par ex. selon le protocole IEEE 802.3 « Ethernet ») ou, dans certains cas, sans fil (par ex. selon le protocole IEEE 802.15 « BlueTooth® »). Ces raccordements sont schématisés sur la figure 1 par des lignes. Les flèches indiquent pour chacun le sens de circulation de l'information.

Le traitement d'un récipient **2** est réalisé de la manière suivante.

Le récipient **2** est, au moyen du support **7,** placé et suspendu dans l'enceinte **5.** L'étanchéité est réalisée, d'une part au niveau du col du récipient **2** entre l'intérieur et l'extérieur de celui-ci (c'est-à-dire dans l'enceinte **5**), et d'autre part entre l'enceinte **5** et la cavité **4.**

Une dépression interne est réalisée dans le récipient **2** au moyen de la pompe **8** à vide primaire commandée par l'unité **25** de contrôle, la pression résiduelle étant de quelques μbars. En d'autres termes, un vide poussé est réalisé dans le récipient **2.** L'expression « dépression interne » est employée pour qualifier la différence (négative) entre la pression résiduelle régnant dans le récipient **2,** et la pression atmosphérique.

Une dépression est également réalisée dans l'enceinte **5** à l'extérieur du récipient **2** au moyen de la pompe **10** à vide secondaire commandée par l'unité **25** de contrôle, de façon à éviter un écrasement de celui-ci sous la différence de pression de part et d'autre de sa paroi latérale. L'expression « dépression externe » est employée pour qualifier la différence (également négative) entre la pression régnant dans l'enceinte **5** et la pression atmosphérique.

Le gaz précurseur est injecté dans le récipient **2** au moyen de l'injecteur **12** commandé par l'unité **25** de contrôle. La pompe **8** à vide est maintenue ouverte pour permettre le renouvellement du gaz précurseur.

Le générateur **15** est activé par l'unité **25** de contrôle. La propagation des micro-ondes dans la cavité **4** produit une superposition d'ondes incidentes et réfléchies, et l'établissement dans la cavité **4,** pour certaines fréquences, d'un champ électrique micro-ondes stationnaire, dont la distribution spatiale n'est pas uniforme et qui présente dans la zone du récipient **2,** grâce à un positionnement particulier des plateaux **21, 22,** une concentration locale d'énergie qui permet l'amorçage d'un plasma dans le gaz précurseur.

Le plasma résulte de la décomposition moléculaire du gaz précurseur par l'énergie micro-ondes concentrée au coeur du récipient **2** La décomposition moléculaire du gaz précurseur (en l'espèce de l'acétylène) produit une soupe d'espèces volatiles variées de type $C_xH_y$, où x et y sont des réels avec $x \geq 0$ et $y \geq 0$, dont une partie au moins est ionique.

Une partie de ces espèces $C_xH_y$ se déposent sur la paroi du récipient **2** (contribuant ainsi à la génération d'une couche mince de carbone amorphe hydrogéné), qu'elles chauffent en lui transférant une partie de leur énergie calorique.

La dépression interne, la dépression externe, l'injection de gaz précurseur et l'onde électromagnétique sont maintenues, pour entretenir le plasma, pendant une durée de traitement prédéterminée comprise entre 1s et 5s.

La distribution spatiale des espèces dans le volume interne délimité par le récipient **2** est non uniforme, car la distribution spatiale de l'énergie des micro-ondes est elle-même non uniforme, en raison de la présence dans la cavité **4** d'objets qui affectent les micro-ondes (notamment le tube **14** qui forme une antenne et le récipient **2** qui forme un diélectrique).

Il en résulte que la couche barrière formée intérieurement sur la paroi du récipient **2** par le dépôt d'espèces issues du plasma n'est pas d'une homogénéité parfaite, son épaisseur présentant des variations locales.

Il est sans doute illusoire de tenter d'obtenir une couche barrière présentant une homogénéité parfaite, c'est-à-dire une épaisseur constante sur l'ensemble de la surface interne de la paroi du récipient **2**. Mais certaines irrégularités dans le dépôt peuvent être aplanies en jouant sur différents paramètres du procédé (pression dans le récipient **2,** pression dans l'enceinte **5,** débit de gaz précurseur, puissance d'émission du générateur **15,** le cas échéant fréquence d'émission du générateur **15,** durée de traitement, position des plateaux **21, 22**).

S'il est difficile de mesurer physiquement l'épaisseur du dépôt autrement que par des tests destructifs, il est en revanche possible de la mesurer indirectement au moyen d'une image thermique du récipient **2** traité, car, comme nous l'avons vu, la paroi du récipient **2** est chauffée par le dépôt d'espèces, et la chaleur transférée à la paroi du récipient **2** est proportionnelle à l'épaisseur du dépôt. Il va de soi que la conduction thermique fait que les variations de température que l'on peut détecter sur la paroi du récipient **2** tendent à s'estomper au fur et à mesure que, le traitement terminé, le récipient **2** refroidit. C'est pourquoi il est préférable de procéder à une cartographie thermique du récipient **2** immédiatement après la fin du traitement.

Si la (les) caméra(s) **20** thermique(s) est (sont) intégrée(s) au poste **3** de formage, la cartographie thermique du récipient **2** peut être réalisée avant que celui-ci ne soit évacué de la cavité **4**. Le montage illustré permet de procéder en ce sens.

Si la caméra **20** thermique est fixe en étant placée au point d'évacuation des récipients **2** de leurs cavités **4** respectives, la cartographie thermique de chaque récipient **2** est réalisée après l'évacuation du récipient **2** de sa cavité **4**. Quelques dixièmes de secondes tout au plus séparant la fin du traitement de l'évacuation du récipient **2** de la cavité **4,** le résultat n'est pas sensiblement différent d'une mesure interne à la cavité **4**.

Le traitement est décrété terminé dès l'extinction du plasma (soit que le générateur **15** a été coupé, soit que l'injection du gaz précurseur a été stoppée). L'expression « immédiatement après la fin du traitement » signifie que l'image thermique du récipient est réalisée à l'instant même de l'extinction du plasma, ou au plus quelques fractions de secondes (au plus une seconde) après cette extinction.

Une cartographie thermique du récipient **2** est cependant inutile si l'on ne dispose pas d'une référence à laquelle la comparer. C'est pourquoi au moins une image **28** thermique de référence d'un modèle idéal de récipient traité est mémorisée dans l'unité **25** de contrôle. Selon un mode de réalisation, plusieurs images **28** thermiques de référence, faites selon plusieurs points de vue, sont mémorisées dans l'unité **25** de contrôle, pour permettre une comparaison avec des images **27** thermiques faites selon les mêmes points de vue.

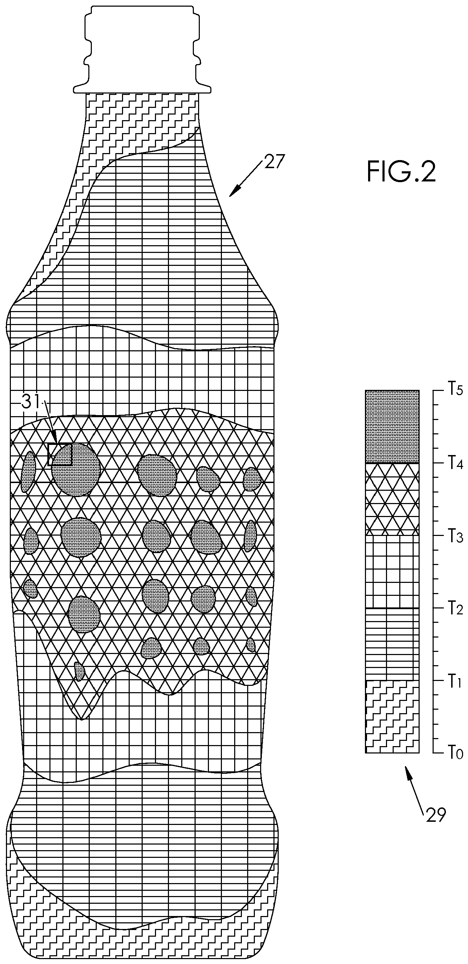

On a représenté sur la figure 2 une image **27** thermique d'un récipient **2** dont le traitement vient d'être achevé. Le domaine infrarouge étant invisible à l'oeil, l'image **27** est retraitée en fausses couleurs pour pouvoir être lue et interprétée dans le domaine visible. Une légende **29** permet de lire et d'interpréter l'image **27**. Les couleurs sont arbitraires ; sur la figure 2, on a, pour des raisons de clarté, représenté différentes gammes de température $[T_i ; T_{i+1}]$ (où i est un entier positif ou nul, les températures étant croissantes suivant la valeur croissante de l'indice i) par des motifs différents. Cinq domaines sont illustrés, représentant des valeurs croissantes de températures :

$[T_0 ; T_1]$ par un motif en zigzag ;
$[T_1 ; T_2]$ par un motif à quadrillage rectangulaire ;
$[T_2 ; T_3]$ par un motif à quadrillage carré ;
$[T_3 ; T_4]$ par un motif à quadrillage triangulaire ;
$[T_4 ; T_5]$ par un motif à points.

Comme le montre l'image **27** thermique du récipient **2,** la température est relativement plus élevée dans une zone médiane de celui-ci, et décroît lorsqu'on s'éloigne de celle-ci pour atteindre des valeurs minimales au voisinage du col et du fond du récipient **2**.

On souhaite pouvoir modifier les paramètres du traitement si celui-ci est décrété défectueux (ce qui se traduit par le fait que l'image **27** du récipient **2** diffère de l'image **28** de référence).

La comparaison des images **27, 28** peut être réalisée par corrélation d'image (au moyen d'un algorithme programmé dans l'unité **25** de contrôle).

Comparer les images **27, 28** dans leur ensemble (par une corrélation d'image dite globale) est faisable mais requiert une grande puissance de calcul sans être nécessairement efficace, tout en étant difficilement interprétable.

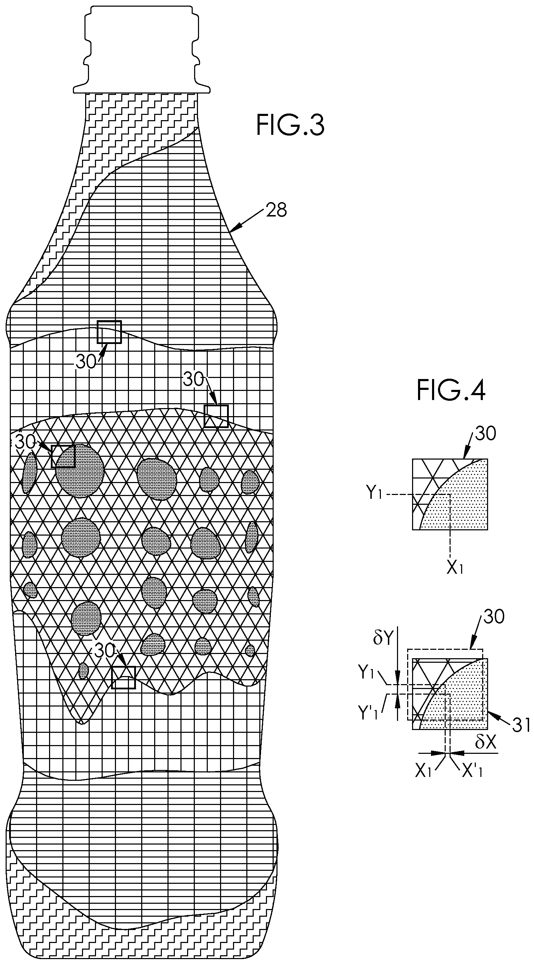

C'est pourquoi il est préférable de procéder à une corrélation d'image locale en sélectionnant une ou plusieurs zones restreinte(s) ou imagette(s) **30** de référence, présumée(s) témoigner à elle(s) seule(s) de la répartition de la couche barrière. Dans l'exemple illustré sur la figure 3, on a représenté quatre imagettes **30** de référence, à contour rectangulaire, dont on en a sélectionné une sur la figure 4 pour illustrer une technique de corrélation d'image susceptible d'être appliquée dans le présent procédé.

L'image **28** de référence étant bidimensionnelle, on repère par des coordonnées $X_n$ (abscisse) et $Y_n$ (ordonnées), respectivement la position suivant un axe horizontal et un axe vertical du centre géométrique d'une imagette **30** de référence, où n est un entier représentant l'indice de l'imagette **30** de référence. Sur la figure 4, on a, par commodité, affecté à l'imagette **30** de référence représentée l'indice n=1. Cette imagette **30** de référence correspond à l'imagette **30** la plus à gauche sur l'image **28** de référence de la figure 3.

Pour effectuer la corrélation d'image appliquée à l'imagette **30** de référence, l'unité **25** de contrôle recherche dans l'image **27** thermique, au voisinage du point de coordonnées $X_1$, $Y_1$, une imagette de même taille, similaire à l'imagette **30** de référence et dont l'écart à celle-ci est minimal. On nomme « imagette corrélée » cette imagette, que l'on repère sous le numéro **31.** Son centre géométrique est repéré par les coordonnées X'₁, Y'₁.

En notant δX l'écart entre X₁ et X'₁, et δY l'écart entre Y₁ et Y'₁, l'imagette **31** corrélée à l'imagette **30** de référence est celle qui minimise la distance E entre les centres des imagettes **29, 30** ($E = \sqrt{\delta X^2 + \delta Y^2}$).

Après avoir évalué cette distance E, l'unité **25** de contrôle la compare à une valeur E₀ de référence mémorisée.

Si pour chaque imagette **31** corrélée la distance E est inférieure à la valeur E₀ de référence, alors l'imagette **31** corrélée est décrétée confondue avec l'imagette **29** de référence et, plus généralement, l'image **27** thermique est décrétée confondue avec l'image **28** de référence. Il en est conclu que le dépôt de la couche barrière est conforme à l'idéal, et les paramètres du procédé sont conservés pour le cycle (ou une série de cycles) suivants.

Si au contraire, pour au moins une imagette **31** corrélée la distance E est supérieure à la valeur E₀ de référence, alors l'imagette **31** corrélée est décrétée différer de l'image **28** de référence.

Dans ce cas, l'unité **25** de contrôle commande une modification de l'un au moins des paramètres du procédé, parmi :

- la dépression interne (à maximiser, en valeur absolue, pour obtenir une meilleure homogénéité),
- la dépression externe (à dépression interne égale, une dépression externe trop faible en valeur absolue peut conduire à un écrasement du récipient **2** mais entraîne une ventilation naturelle du récipient **2** qui évite le risque de brûlure ; a contrario, une dépression externe trop élevée en valeur absolue limite le refroidissement et augmente en conséquence le risque de brûlure du récipient **2**),
- le débit de gaz précurseur (un débit trop faible ne permet pas d'obtenir une épaisseur de couche suffisante ; un débit trop important crée, a contrario, des points chauds qui peuvent provoquer des brûlures sur la paroi du récipient **2**),
- la puissance d'émission du générateur **15** (une puissance trop faible augmente les écarts de température ; a contrario, une puissance trop importante crée aussi des points chauds qui peuvent provoquer des brûlures sur la paroi du récipient **2**) ;
- la durée du traitement plasma (c'est-à-dire l'intervalle de temps séparant l'amorçage et l'extinction du plasma ; une durée de traitement trop importante augmente le risque de brûlure ; une durée trop faible peut conduire à une épaisseur de couche trop faible) ;
- le cas échéant, la position des plateaux **21, 22** ;
- le cas échéant, la fréquence d'émission du générateur **15.**

Le cycle est répété avec un autre récipient **2,** et le(s) paramètre(s) est (sont) modifié(s) tant que la corrélation fournit un résultat négatif, c'est-à-dire que l'image **27** thermique est décrétée non confondue avec l'image **28** de référence.

Le procédé qui vient d'être décrit permet, en premier lieu, d'améliorer l'homogénéité de la couche barrière, et donc la qualité des récipients traités.

Il permet, en deuxième lieu, d'accroître la répétitivité du cycle de traitement d'un récipient **2** à l'autre en évitant les dérives, grâce aux images thermiques qui peuvent être réalisées à chaque cycle (c'est-à-dire pour chaque récipient **2**) ou périodiquement (par ex. tous les dix cycles).

## Revendications

1. Procédé de traitement d'un récipient (**2**) par plasma pour le dépôt, sur une face interne du récipient (**2**), d'une couche barrière, ce procédé comprenant les opérations consistant à :

   - introduire le récipient (**2**) dans une enceinte (**5**) transparente aux micro-ondes ;
   - créer dans le récipient (**2**) une dépression interne d'une valeur prédéterminée ;
   - créer dans l'enceinte (**5**) une dépression externe d'une valeur prédéterminée ;
   - injecter dans le récipient (**2**) un gaz précurseur selon un débit prédéterminé ;
   - soumettre l'enceinte (**5**) à une onde électromagnétique de fréquence prédéterminée dans le domaine des micro-ondes et de puissance prédéterminée, de façon à exciter un plasma dans le gaz précurseur ;
   - maintenir la dépression interne, la dépression externe, l'injection de gaz précurseur et l'onde électromagnétique pour entretenir le plasma pendant une durée de traitement prédéterminée ;
   - éteindre le plasma ;

   ce procédé étant **caractérisé en ce qu'**il comprend en outre les opérations consistant à :

   - après l'extinction du plasma, réaliser une image (**27**) thermique du récipient (**2**) ;
   - comparer l'image (**27**) thermique du récipient avec une image (**28**) thermique de référence mémorisée ;
   - si l'image (**27**) thermique du récipient (**2**) diffère de l'image (**28**) thermique de référence, modifier au moins l'un des paramètres suivants : dépression interne, dépression externe, débit de gaz précurseur, fréquence des micro-ondes, puissance des micro-ondes, durée du traitement.

2. Procédé selon la revendication 1, dans lequel, la dépression interne étant réalisée au moyen d'une pompe (**8**) à vide primaire, la modification de la dépression interne consiste à modifier le débit de cette pompe (**8**) à vide primaire.

3. Procédé selon la revendication 1, **caractérisé en ce que**, le générateur (**15**) étant un magnétron et l'enceinte (**5**) étant logée dans une cavité (**4**) munie de plateaux (**21, 22**) mobiles réalisés dans un matériau électriquement conducteur, la position des plateaux fait partie des paramètres modifiables si l'image (**27**) thermique du récipient (**2**) diffère de l'image (**28**) thermique de référence.

4. Procédé selon la revendication 1 ou la revendication 2, dans lequel, la dépression externe étant réalisée au moyen d'une pompe (**10**) à vide secondaire, la modification de la dépression externe consiste à modifier le débit de cette pompe (**10**) à vide secondaire.

5. Procédé selon l'une des revendications précédentes, dans lequel, le gaz précurseur étant injecté dans le récipient (**2**) au moyen d'un injecteur (**12**), la modification du débit de gaz précurseur consiste à régler l'ouverture de l'injecteur (**12**).

6. Procédé selon l'une des revendications précédentes, dans lequel la comparaison est effectuée par corrélation d'image.

7. Procédé selon la revendication 6, dans lequel la comparaison est effectuée par corrélation d'image locale.

8. Installation pour le traitement d'un récipient (**2**) par plasma pour le dépôt, sur une face interne du récipient (**2**), d'une couche barrière, cette installation comprenant :

   - une enceinte (**5**) transparente aux micro-ondes, apte à accueillir le récipient (**2**) à traiter ;
   - un circuit primaire de vide apte à créer dans le récipient (**2**) une dépression interne d'une valeur prédéterminée ;
   - un circuit secondaire de vide apte à créer dans l'enceinte (**5**) une dépression externe d'une valeur prédéterminée ;
   - un dispositif (**11**) d'injection d'un gaz précurseur dans le récipient (**2**) selon un débit prédéterminé ;
   - un générateur (**15**) d'ondes électromagnétiques dans le domaine des micro-ondes à une fréquence prédéterminée et de puissance prédéterminée, propres à exciter un plasma dans le gaz précurseur ;

cette installation étant **caractérisée en ce qu'**elle comprend en outre :

   - une caméra (**20**) thermique propre à réaliser une image (**27**) thermique du récipient (**2**) ;
   - une unité (**24**) de contrôle programmée pour :

      - comparer l'image (**27**) thermique du récipient avec une image (**28**) thermique de référence mémorisée ;
      - si l'image (**27**) thermique du récipient (**2**) diffère de l'image (**28**) thermique de référence, modifier au moins l'un des paramètres suivants : dépression interne, dépression externe, débit de gaz précurseur, fréquence des micro-ondes, puissance des micro-ondes, durée du traitement.

**Patentansprüche**

1. Verfahren zum Bearbeiten eines Behälters (2) durch Plasma, um auf einer Innenfläche des Behälters (2) eine Barrierenschicht abzuscheiden, wobei dieses Verfahren die folgenden Schritte umfasst:

   - Einsetzen des Behälters (2) in eine für Mikrowellen durchlässige Umschließung (5);
   - Erzeugen in dem Behälter (2) eines inneren Unterdrucks mit einem vorgegebenen Wert;
   - Erzeugen in der Umschließung (5) eines äußeren Unterdrucks mit einem vorgegebenen Wert;
   - Einleiten in den Behälter (2) eines Vorläufergases mit einem vorgegebenen Durchfluss;
   - Beaufschlagen des Behälters (5) mit einer elektromagnetischen Welle mit vorgegebener Frequenz im Bereich der Mikrowellen und mit vorgegebener Leistung, derart, dass in dem Vorläufergas ein Plasma erregt wird;
   - Aufrechterhalten des inneren Unterdrucks, des äußeren Unterdrucks, des Einleitens des Vorläufergases und der elektromagnetischen Welle, um das Plasma während einer vorgegebenen Bearbeitungsdauer zu unterhalten;
   - Löschen des Plasmas;

wobei dieses Verfahren **dadurch gekennzeichnet ist, dass** es außerdem die folgenden Schritte umfasst:

   - nach dem Löschen des Plasmas Erzeugen eines Wärmebildes (27) des Behälters (2);
   - Vergleichen des Wärmebildes (27) des Behälters mit einem gespeicherten Referenz-Wärmebild (28);
   - falls sich das Wärmebild (27) des Behälters (2) von dem Referenz-Wärmebild (28) unterscheidet, Modifizieren wenigstens eines der folgenden Parameter: innerer Unterdruck, äußerer Unterdruck, Vorläufergas-Durchfluss, Frequenz der Mikrowellen, Leistung der Mikrowellen, Bearbeitungsdauer.

2. Verfahren nach Anspruch 1, wobei der innere Unterdruck mittels einer primären Unterdruckpumpe (8) erzeugt wird, wobei die Modifikation des inneren Unterdrucks darin besteht, den Durchfluss dieser primären Unterdruckpumpe (8) zu modifizieren.

3. Verfahren nach Anspruch 1, **dadurch gekennzeichnet, dass** der Generator (15) ein Magnetron ist und die Umschließung (5) in einem Hohlraum (4) aufgenommen ist, der mit beweglichen Platten (21, 22) versehen ist, die aus einem elektrisch leitenden Material hergestellt sind, wobei die Position der Platten zu den modifizierbaren Parametern gehört, falls sich das Wärmebild (27) des Behälters (2) von dem Referenz-Wärmebild (28) unterscheidet.

4. Verfahren nach Anspruch 1 oder Anspruch 2, wobei der äußere Unterdruck mittels einer sekundären Unterdruckpumpe (10) erzeugt wird, wobei die Modifikation des äußeren Unterdrucks darin besteht, den Durchfluss dieser sekundären Unterdruckpumpe (10) zu modifizieren.

5. Verfahren nach einem der vorhergehenden Ansprüche, wobei das Vorläufergas in dem Behälter (2) mittels einer Einleitungseinrichtung (12) eingeleitet wird, wobei die Modifikation des Vorläufergas-Durchflusses darin besteht, die Öffnung der Einleitungseinrichtung (12) zu regulieren.

6. Verfahren nach einem der vorhergehenden Ansprüche, wobei der Vergleich durch Bildkorrelation ausgeführt wird.

7. Verfahren nach Anspruch 6, wobei der Vergleich durch Korrelation lokaler Bilder ausgeführt wird.

8. Anlage für die Bearbeitung eines Behälters (2) durch Plasma, um auf einer Innenfläche des Behälters (2) eine Barrierenschicht abzuscheiden, wobei diese Anlage Folgendes umfasst:

- eine für Mikrowellen durchlässige Umschließung (5), die den zu bearbeitenden Behälter (2) aufnehmen kann;
- einen primären Unterdruckkreis, der in dem Behälter (2) einen inneren Unterdruck mit einem vorgegebenen Wert erzeugen kann;
- einen sekundären Unterdruckkreis, der in der Umschließung (5) einen äußeren Unterdruck mit einem vorgegebenen Wert erzeugen kann;
- eine Vorrichtung (11) zum Einleiten eines Vorläufergases in den Behälter (2) mit einem vorgegebenen Durchfluss;
- einen Generator (15) für elektromagnetische Wellen im Bereich der Mikrowellen mit einer vorgegebenen Frequenz und mit vorgegebener Leistung, die ein Plasma in dem Vorläufergas erregen können;

wobei diese Anlage **dadurch gekennzeichnet ist, dass** sie außerdem Folgendes umfasst:

- eine Wärmekamera (20), die ein Wärmebild (27) des Behälters (2) erzeugen kann;
- eine Steuereinheit (24), die programmiert ist zum:
- Vergleichen des Wärmebildes (27) des Behälters mit einem gespeicherten Referenz-Wärmebild (28);
- und, falls sich das Wärmebild (27) des Behälters (2) von dem Referenz-Wärmebild (28) unterscheidet, Modifizieren wenigstens eines der folgenden Parameter: innerer Unterdruck, äußerer Unterdruck, Vorläufergas-Durchfluss, Frequenz der Mikrowellen, Leistung der Mikrowellen, Bearbeitungsdauer.

## Claims

1. Method for treating a receptacle (2) using plasma to deposit, on an inside surface of the receptacle (2), a barrier layer, this method comprising the operations consisting in:

- placing the receptacle (2) inside a chamber (5) that is transparent to microwaves;
- creating an internal depression of a predetermined value in the receptacle (2);
- creating an external depression of a predetermined value in the chamber (5);
- injecting a precursor gas into the receptacle (2) at a predetermined flow rate;
- subjecting the chamber (5) to an electromagnetic wave of predetermined frequency in the microwave range and of predetermined power, so as to excite a plasma in the precursor gas;
- maintaining the internal depression, the external depression, the injection of precursor gas and the electromagnetic wave to sustain the plasma for a predetermined duration of treatment;
- extinguishing the plasma;

this method being **characterized in that** it further comprises the operations consisting in:

- after extinguishing the plasma, producing a thermal image (27) of the receptacle (2);

- comparing the thermal image (27) of the receptacle with a stored reference thermal image (28);
- if the thermal image (27) of the receptacle (2) differs from the reference thermal image (28), modifying at least one of the following parameters: internal depression, external depression, precursor gas flow rate, microwave frequency, microwave power, treatment duration.

2. Method according to Claim 1, wherein, the internal depression being created by means of a primary vacuum pump (8), modifying the internal depression consists in modifying the flow rate of this primary vacuum pump (8).

3. Method according to Claim 1, **characterized in that**, the generator (15) being a magnetron and the chamber (5) being housed in a cavity (4) provided with movable platforms (21, 22) that are made of an electrically conductive material, the position of the platforms forms part of the modifiable parameters if the thermal image (27) of the receptacle (2) differs from the reference thermal image (28).

4. Method according to Claim 1 or Claim 2, wherein, the external depression being created by means of a secondary vacuum pump (10), modifying the external depression consists in modifying the flow rate of this secondary vacuum pump (10).

5. Method according to one of the preceding claims, wherein, the precursor gas being injected into the receptacle (2) by means of an injector (12), modifying the precursor gas flow rate consists in adjusting the opening of the injector (12).

6. Method according to one of the preceding claims, wherein the comparison is made by image correlation.

7. Method according to Claim 6, wherein the comparison is made by local image correlation.

8. Installation for treating a receptacle (2) using plasma to deposit, on an inside surface of the receptacle (2), a barrier layer, this installation comprising:

- a chamber (5) that is transparent to microwaves, capable of accommodating the receptacle (2) to be treated;
- a primary vacuum circuit for creating an internal depression of a predetermined value in the receptacle (2);
- a secondary vacuum circuit for creating an external depression of a predetermined value in the chamber (5) ;
- a device (11) for injecting a precursor gas into the receptacle (2) at a predetermined flow rate;
- a generator (15) for generating electromagnetic waves in the microwave range at a predetermined frequency and of predetermined power, capable of exciting a plasma in the precursor gas;

this installation being **characterized in that** it further comprises:

- a thermal camera (20) for producing a thermal image (27) of the receptacle (2);
- a programmed control unit (24) for:

- comparing the thermal image (27) of the receptacle with a stored reference thermal image (28);
- if the thermal image (27) of the receptacle (2) differs from the reference thermal image (28), modifying at least one of the following parameters: internal depression, external depression, precursor gas flow rate, microwave frequency, microwave power, treatment duration.

FIG.1

FIG.2

FIG.3

28

30

30

30

30

FIG.4

30

Y₁

X₁

$Y_1$

$X_1$

30

δY

Y₁

Y'₁

31

δX

X₁  X'₁

**EP 3 262 210 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1068032 A
- CA 2859157
- EP 1881088 A
- WO 2011015330 A
- US 20100007100 A
- US 20100206232 A

**Littérature non-brevet citée dans la description**

- Encyclopédie Ullmann de l'industrie chimique. vol. A26, 720